# EUROPEAN PATENT SPECIFICATION

(11) **EP 2 351 474 B1**
(45) Date of publication and mention of the grant of the patent: **17.04.2013**
(21) Application number: 08876275.2
(22) Date of filing: 03.11.2008
(51) Int. Cl.: H05K 7/20

(54) **CLIMATE CONTROL IN A RADIO NETWORK NODE**
KLIMAREGELUNG IN EINEM FUNKNETZKNOTEN
RÉGULATION DE CLIMAT DANS UN NOEUD DE RÉSEAU RADIO

(43) Date of publication of application: 03.08.2011
(73) Proprietor: Telefonaktiebolaget L M Ericsson (publ), 164 83 Stockholm (SE)
(72) Inventor: HEDBERG, Klas, S-141 38 Huddinge (SE); JONSSON, Fredrik, S-197 34 Bro (SE)
(74) Representative: Kühn, Friedrich Heinrich
(86) International application number: PCT/SE2008/051250
(87) International publication number: WO 2010/050864

(56) References cited:
- EP-A1- 1 906 720
- US-A- 4 475 358
- US-A- 5 121 291
- US-A- 6 039 111
- US-A- 6 104 003
- US-A1- 2001 042 614
- US-A1- 2004 148 948
- US-B2- 7 061 763

## Description

### TECHNICAL FIELD

The present invention relates to an arrangement and a method in a radio network node for cooling electronic equipment within the radio network node.

### BACKGROUND

Generally, a radio communication system of today comprises an access network and a number of communication devices. The access network is built up of several nodes, in particular, radio base stations. The primary task of a radio base station is to send and receive information to/from the communication devices within reach of the radio base station. In many cases, the base station is run 24 hours a day. Therefore, it is of particular interest and importance to ensure that the base station is operable predictably and reliably. The radio base station further comprises a cabinet, which comprises an enclosure for housing circuitry, or electronic equipment, for performing different tasks of the radio base station. For example, the circuitry may comprise a power control unit, a radio unit and a filtering unit for performing corresponding tasks.

Due to extensive operation of the radio base station, heat generated in the circuitry of the base station, in particular the radio unit, may not always dissipate naturally to a sufficiently high degree. Instead, heat is accumulated in the circuitry and temperature of the circuitry increases. The increased temperature of the circuitry may decrease the performance of circuitry within the radio base station, e.g. the circuitry within the radio base station may fail. Consequently, unpredicted interruptions in operation of the base station may occur. This is clearly not desired.

Hence, as is known in the art, systems for cooling of heat generating equipment within a radio base station have been developed. These systems are sometimes referred to as climate systems or climate control systems for radio base stations.

According to a known technique for cooling heat generating equipment in radio base stations, fans are used to circulate air through or over the heat generating equipment and through or over one side of a heat exchanger (i.e. an internal side within the enclosure). Moreover, further fans are used to force ambient air through or over the other side of the heat exchanger (i.e. an external side within the cabinet). The heat exchanger comprises a refrigerant that absorbs heat from the air, heated by the electronic equipment, at the internal side within the enclosure. As a result, a transition from liquid phase to gas phase of the refrigerant occurs. The portion of the heat exchanger that is located at the internal side within the enclosure is called evaporator. The gas is, by evaporation, forced to the external side of the heat exchanger, where it dissipates heat to ambient air. As a result, a transition from gas phase to liquid phase of the refrigerant occurs in the external side of the heat exchanger. The portion of the heat exchanger that is located on the external side is called condenser. At this stage, gravity forces the liquid to flow towards the evaporator.

An example of the known technique for cooling is disclosed in US 6,026,891, which document relates to a cooling device for use in a radio base station and which comprises means for cooling an interior of a housing for accommodating a heat generating member such as an electronic component part. In the prior art, heat transfer from the heat generating electronic equipment inside the housing is performed by using a heat exchanger including a boiling and condensing refrigerant. To improve the cooling capacity, air regulating devices, e.g. fans, are used to force the air on both or either sides of the heat exchanger.

The device further comprises a controller for controlling the entire operation of the cooling device and a sensor for detecting an air temperature in the housing and transmitting a signal of the detected air temperature to the controller. The normal control mode is to regulate the speed of each air regulating device as a function of the air temperature inside the housing.

However, to measure the relevant and correct air temperature is difficult since an air temperature sensor normally measures the temperature in a point, and the air temperature can be uneven. Further, the air temperature sensor can also be influenced by radiation and local heat sources, e.g. a heater, which is an increasing problem with future very compact climate systems.

Other arrangements for cooling electronic equipment in a radio network node are disclosed in EP 1 906 720 and US 6 039 111.

### SUMMARY

It is an object of the present invention to alleviate at least some of the above disadvantages and provide an improved arrangement and method for cooling in a radio network node.

According to a first aspect of the invention the object is achieved by an arrangement for controlling the cooling of electronic equipment in a radio network node. The arrangement comprises a closed space for housing the electronic equipment and a heat exchanger for transporting heat from the closed space. A first flow regulating device is arranged for circulating a cooling fluid within the closed space and a second flow regulating device is arranged for circulating a cooling fluid outside the closed space. The arrangement further comprises at least one sensor for measuring temperature in the arrangement and a controller for controlling at least one of the first and second flow regulating devices based on at least one temperature measurement, wherein the at least one sensor is located on a fixed member within the arrangement.

According to a second aspect of the invention the object is achieved by a method in a radio network node arrangement for cooling electronic equipment within the arrangement. The arrangement comprises a closed space for housing the electronic equipment and a heat exchanger for transporting heat from the closed space. The arrangement further comprises a first flow regulating device for circulating a cooling fluid within the closed space and a second flow regulating device for circulating a cooling fluid outside the closed space. At least one sensor measures at least one temperature on a fixed member within the arrangement. A controller receives the at least one measured temperature and controls at least one of the first and second flow regulating devices based on that temperature(s).

An advantage of the present invention is that the temperature used in accordance with the present invention for controlling the at least one of the first and second flow regulating devices is a stable temperature safe from influences such as radiation and/or local heat sources, e.g. heaters. By measuring a temperature on a fixed member within the arrangement, a reliable and stable value is provided to the controller used for controlling the flow regulating devices. This results in an efficient, reliable and improved cooling of electronic equipment within a radio network node in accordance with the object of the present invention.

### BRIEF DESCRIPTION OF THE DRAWINGS

The various aspects of the invention, including its particular features and advantages, will be readily understood from the following detailed description and the accompanying drawings, in which
**Figure 1** illustrates a schematic block diagram of parts within the arrangement within a network node according to the invention, and
**Figure 2** is a flow chart showing the methods according to the invention.

### DETAILED DESCRIPTION OF PREFERRED EMBODIMENTS

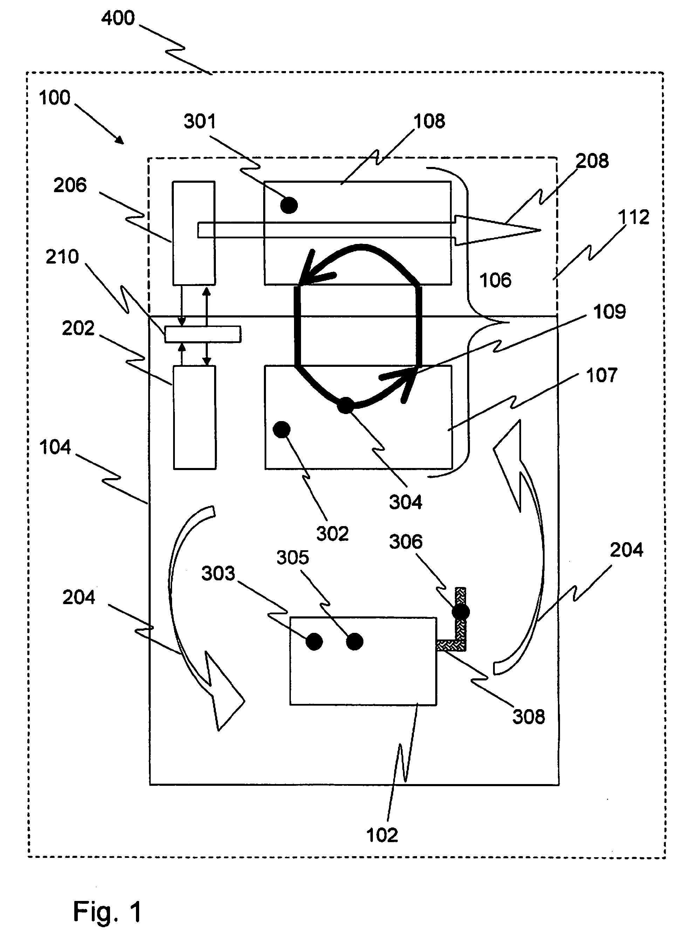

**Figure 1** shows an arrangement 100 in a radio network node 400 for cooling electronic equipment 102 within the arrangement 100. The arrangement comprises a closed space 104, defined by wall members 104 of the closed space for housing the electronic equipment 102. The arrangement 100 further comprises a heat exchanger 106 for transporting heat from the closed space 104 to outside 112 of the closed space. The heat exchanger 106 may comprise of one or several heat exchangers in series or in parallel.

A first flow regulating device 202 is arranged for circulating a cooling fluid 204 within the closed space 104. The heat exchanger 106 takes up heat from the cooling fluid 204 within the closed space and dissipates it outside 112 the closed space. A second flow regulating device 206 is arranged for circulating an outer cooling fluid 208 outside 112 the closed space. The flow regulating devices 202, 206 may be for example fans. The fluid regulating devices 202, 206 are regulated by a controller 210 connected to the first and second flow regulating devices respectively. The controller 210 is preferably located within the closed space in the vicinity of the first flow regulating device 202. The arrangement 100 further comprises at least one sensor 301, 302, 303, 304, 305, 306 for measuring temperature within the closed space 104 or outside 112 the closed space.

In the embodiment shown in **Figure 1**, the heat exchanger 106 includes a boiling and condensing refrigerant i.e. a refrigerant fluid, referred to as arrow 109. The heat exchanger 106 has a first portion 107 located within the closed space 104. This first portion 107 of the heat exchanger 106 is an evaporator. In the first portion 107 the refrigerant fluid 109 evaporates and takes up heat energy from the cooling fluid 204 that has been warmed up by the electronic equipment 102 inside the closed space 104. The heat exchanger 106 also has a second portion 108 located outside 112 the closed space 104. The second portion 108 of the heat exchanger is a condenser. In the second portion 108 the refrigerant fluid 109 is condensed and heat is dissipated to the outer cooling fluid 208 outside 112 of the closed space. The refrigerant flow 109 between the first portion 107 and the second portion 108 is generated either by gravitation from the density difference between liquid and gas phases of the refrigerant, as in a thermosiphon or by gravitation and capillary forces, as in a heat pipe. The first and second fluid regulating devices 202, 206 are used to force the cooling fluids in directions indicated by arrows 204, 208 on both or either sides of the heat exchanger 106 to improve the cooling capacity.

The cooling of the electronic equipment 102 within the arrangement is controlled by controlling at least one of the first and second flow regulating devices 202, 206 based on at least one temperature measurement wherein the at least one sensor 301, 302, 303, 304, 305, 306 is located on a fixed member 102, 104, 106, 112, 308 within the arrangement 100.

The sensors 301, 302, 303, 304, 305, 306 shown in Figure 1 are shown for illustrative purpose and it is to be understood that still further sensors may be positioned on further fixed members within the arrangement 100.

The fixed member may be represented by
- a measuring piece 308 located within the arrangement 100,
- any part of the electronic equipment 102,
- any part of the heat exchanger 106, 107, 108
- a wall member 104, 112 of the arrangement 100
or a combination thereof. By measuring a temperature on a fixed member within the arrangement 100, a reliable and stable value is provided to the controller 210 used for controlling the flow regulating devices 202, 206. This results in an efficient, reliable and improved cooling of electronic equipment 102 within the network node 400.

In an embodiment of the invention, the measuring piece 308 protrudes from the electronic equipment 102 into the cooling fluid 204 in the closed space 104. An advantage with this embodiment is that the change in temperature of the measuring piece involves a certain inertia or delay, which means that measuring piece 308 will have a similar temperature to that in the electronic equipment 102 during a cold start up.

In a further embodiment of the invention (not shown in Fig. 1), the measuring piece 308 protrudes from an outside 112 wall member into the outer cooling fluid 208 outside the closed space. By regulating the cooling performance with an external sensor in combination with any of the other suggested sensors gives the possibility to chose the most efficient and appropriate cooling mode. For example, at lower ambient temperatures it is very efficient to start the second flow regulating device 206 and take the temperature inside the closed space 104 down, whereas at higher ambient temperatures in a situation when the interior is already close to the ambient it will be less noisy to speed up the first flow regulating device 202. For arrangements in which the heat dissipation can vary drastically, as is the case in the radio network node 400 this controlling arrangement makes it possible to optimize the cooling depending on heat dissipation and ambient conditions.

In an embodiment of the invention, the fixed member is represented by a heat sensitive part of the electronic equipment or a heat sink of the electronic equipment. A sensor 303, 305 may be positioned for example on or near a temperature sensitive part of the electronic equipment 102 or in a heat sink on the electronic equipment. The equipment temperature is often the limiting factor for the life length or reliability of the arrangement. The equipment temperature depends on both the cooling fluid 204 temperature inside the closed space 104, the heat transfer to the cooling fluid 204 inside the closed space and the heat dissipation of the electronic equipment 102. By measuring the temperature of the electronic equipment 102 all these factors are taken into account. Also, in case of a sudden increase in heat generation within the system, for example in a starting up mode, a fast response from the cooling system can be achieved.

In an embodiment of the invention the fixed member 102, 104, 106, 112, 308 is represented by a first portion 107 of the heat exchanger 106 located in the closed space 104. For measuring a temperature of the first portion 107 of the heat exchanger a sensor 302 may be positioned somewhere on the piping of the first portion 107, the evaporator, of the heat exchanger 106 within the closed space 104. The temperature of the evaporator piping on the internal parts of the heat exchanger depends on the temperature of the cooling fluid 204 inside the closed space, the fluid 208 outside 112 the closed space and how the fluid regulating devices are regulated. The most significant influence of this temperature and the capacity of the heat exchanger 106 is the amount of fluid flow 208 over the second portion 108 of the heat exchanger 106, possibly generated by a the second fluid regulating device 206 outside the closed space. The evaporator piping temperature gives an even value temperature as heat is distributed in the material of the piping.

In an embodiment of the invention, the fixed member 102, 104, 106, 112, 308 is represented by a second portion 108 of the heat exchanger 106 located outside 112 the closed space. For measuring a temperature of the second portion 108 , the condenser, of the heat exchanger 106 a sensor 301 can be positioned somewhere on the condenser piping outside 112 the closed space. The temperature of the condenser piping on the external parts of the heat exchanger depends on the fluid flow 208 outside the arrangement, the heat transfer in the heat exchanger 106 and how the fluid regulating devices 202, 206 are regulated. Normally, the fluid flow 208 outside the arrangement 100 is the ambient air.

In an embodiment of the invention, the fixed member 102, 104, 106, 112, 308 is represented by a refrigerant fluid 109 circulating in the heat exchanger 106. For measuring a temperature of the refrigerant fluid 109 within the heat exchanger 106 a sensor 304 may be positioned somewhere on the inside or on the outside of the piping of the first portion 107 of the heat exchanger 106. The refrigerant 109 temperature is slightly lower than the mean temperature of the cooling fluid 204 that has passed through or over the first portion 107 and slightly higher than the mean temperature of the cooling fluid 208 surrounding or that has passed through or over the second portion 108 of the heat exchanger 106. The refrigerant 109 temperature is a stable temperature safe from influences such as radiation and/or local heat sources (heaters). It also gives a mean value of the cooling fluid 204 temperature over the first portion 107 of the heat exchanger 106.

In an embodiment of the invention the sensor is a temperature sensor.

In another embodiment of the invention the sensor is a pressure sensor for indirectly measuring the temperature. For example, for measuring the temperature of the refrigerant fluid a pressure sensor may be used. By determining pressure in the refrigerant fluid 109 circuit, the temperature of the refrigerant fluid can be established. Since there is always a saturated condition in the refrigerant circuit 109, the relation between temperature and pressure for a chosen refrigerant can be established through reference data for each refrigerant.

The dotted line having reference number 112 illustrates wall members outside 112 the closed space. The second portion 108 of the heat exchanger 106 and the second flow regulation device 206 are located outside 112 the closed space and are in contact with the ambient air.

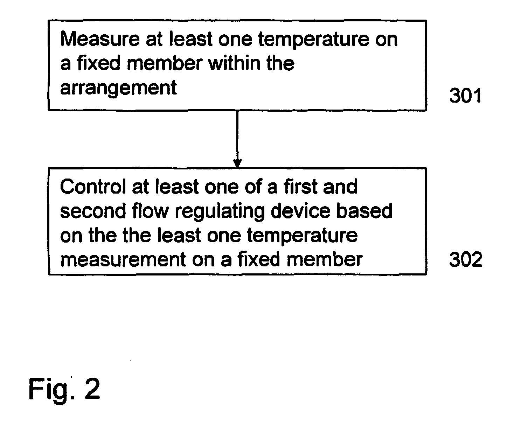

The method steps in the arrangement 100 for controlling cooling of electronic equipment 102 in a radio network node arrangement 100 will now be described with reference to a flow chart depicted in Figure 2. As mentioned above, the arrangement 100 comprises a closed space 104 for housing the electronic equipment 102, a heat exchanger 106 for transporting heat from the closed space and a first flow regulating device 202 for circulating a cooling fluid 204 within the closed space 104 and a second flow regulating device 206 for circulating an outer cooling fluid 208 outside 112 the closed space.
- 301.: At least one sensor measures a temperature on a fixed member within the arrangement.
- 302.: At least one of the first and second flow regulating devices are controlled based on at least one temperature measurement.

According to the method of the present invention, at least one temperature is measured on a fixed member 102, 104, 106, 112, 308 in the arrangement 100 wherein a reliable and stable value is provided to the controller 210 used for controlling the flow regulating devices 202, 204. This results in an efficient and reliable cooling of the electronic equipment 102 within the radio network node 400.

### DEFINITIONS

In this application the term fixed member is used. The expression fixed member shall be interpreted to mean any member of a radio network node arrangement, inside the closed space or outside the closed space that has a solid, semi-solid or liquid phase, such as any part of the electronic equipment, any part of the heat exchanger, the flow generating devices, any part of the construction elements of the arrangement, for example wall members, racks for holding equipment as well as batteries and battery compartments within the arrangement.

Further, the fixed member may be a piece of material without any practical or mechanical function but located within the arrangement to act as a measuring piece, protruding slightly from its fixing point and made of preferably a metallic, polymeric or composite material.

It is to be understood that the heat exchanger may be an air-to-air heat exchanger, for example a plate heat exchanger, or a boiling and condensing heat exchanger comprising a refrigerant fluid.

It is to be understood that the radio network node may be a Radio Base Station (RBS) or any other kind of node in a radio communication system, which node comprises heat generating electronic equipment. Examples of other kinds of nodes are transmission nodes, Remote Subscriber Switches (RSS) and nodes with similar functionality.

When using the word "comprise" or "comprising" it shall be interpreted as non-limiting, in the meaning of "consist at least of".

## Claims

1. An arrangement (100) in a radio network node (400) for cooling electronic equipment (102) within the arrangement (100), the arrangement comprising
- a closed space (104) for housing the electronic equipment (102),
- a heat exchanger (106) for transporting heat from the closed space (104),
- a first flow regulating device (202) for circulating a cooling fluid (204) within the closed space (104),
- a second flow regulating device (206) for circulating an outer cooling fluid (208) outside (112) the closed space (104) for dissipating heat from the heat exchanger (106),
- at least one sensor (301, 302, 303, 304, 305, 306) for measuring temperature in the arrangement, wherein the at least one sensor (301, 302, 303, 304, 305, 306) is located on a fixed member (102, 106, 112, 308) within the arrangement (100) for measuring the temperature of the fixed member (102, 106, 112, 308), the fixed member (102, 106, 112, 308) being any member of the arrangement (100) inside the closed space (104) or outside the closed space (104) that has a solid, semi-solid or liquid phase,
- a controller (210) for controlling at least one of the first and second flow regulating devices (202, 206) based on the at least one temperature measurement of the fixed member (102, 106, 112, 308).

2. Arrangement according to claim 1, wherein the fixed member (102, 104, 106, 112, 308) is represented by
- a measuring piece (308) located within the arrangement (100),
- any part of the electronic equipment (102),
- any part of the heat exchanger (106, 107, 108, 109),
- a wall member (104, 112) of the arrangement (100)
or a combination thereof.

3. Arrangement according to claim 2, wherein the measuring piece (308) protrudes from the electronic equipment (102) into the cooling fluid (204) in the closed space (104).

4. Arrangement according to claim 2, wherein the measuring piece (308) protrudes from an outside (112) wall member into the outer cooling fluid (208) outside the closed space.

5. Arrangement according to claim 2, wherein the fixed member (102, 104, 106, 112, 308) is represented by a heat sensitive part or by a heat sink on the electronic equipment (102).

6. Arrangement according to claim 2, wherein the fixed member (102, 104, 106, 112, 308) is represented by a first portion (107) of the heat exchanger (106) located in the closed space (104).

7. Arrangement according to claim 2, wherein the fixed member (102, 104, 106, 112, 308) is represented by a second portion (108) of the heat exchanger (106) located outside (112) the closed space.

8. Arrangement according to claim 2, wherein the fixed member (102, 104, 106, 112, 308) is represented by a refrigerant fluid (109) circulating in the heat exchanger (106).

9. Arrangement according to claim 1 to 4, wherein the sensor (301, 302, 303, 304, 305, 306) is a temperature sensor.

10. Arrangement according to claim 8, wherein the sensor (304) is a pressure sensor (304) for indirectly detecting a temperature.

11. Arrangement according to claim 7, wherein the second portion (108) of the heat exchanger 106 and the second flow regulation device (206) are in contact with the ambient air.

12. Arrangement according to any of the preceding claims, wherein the radio network node is a radio base station.

13. A method in a radio network node arrangement (100) for cooling electronic equipment (102) within the arrangement (100), the arrangement comprising
- a closed space (104) for housing the electronic equipment (102)
- a heat exchanger (106) for transporting heat from the closed space (104),
- a first flow regulating device (202) for circulating a cooling fluid (204) within the closed space (104),
- a second flow regulating device (206) for circulating a cooling fluid (208) outside (112) the closed space or dissipating heat from the heat exchanger (106), the method comprising the steps of:
- *measuring* the temperature of a fixed member (102, 104, 106, 112, 308) within the arrangement (100) with at least one sensor (301, 302, 303, 304, 305, 306), the fixed member (102, 106, 112, 308) being any member of the arrangement (100) inside the closed space (104) or outside the closed space (104) that has a solid, semi-solid or liquid phase, and
- *controlling* at least one of the first and second flow regulating devices (202, 206) based on the at least one temperature measurement of the fixed member.

## Patentansprüche

1. Anordnung (100) in einem Funknetzknoten (400) zum Kühlen von elektronischen Geräten (102) innerhalb der Anordnung (100), wobei die Anordnung umfasst:
- einen geschlossenen Raum (104) zum Aufnehmen der elektronischen Geräte (102),
- einen Wärmetauscher (106) zum Befördern von Wärme aus dem geschlossenen Raum (104),
- eine erste Strömungsregulierungsvorrichtung (202) zum Zirkulierenlassen eines Kühlfluids (204) innerhalb des geschlossenen Raums (104),
- eine zweite Strömungsregulierungsvorrichtung (206) zum Zirkulierenlassen eines äußeren Kühlfluids (208) außerhalb (112) des geschlossenen Raums (104) zum Ableiten von Wärme aus dem Wärmetauscher (106),
- mindestens einen Sensor (301, 302, 303, 304, 305, 306) zum Messen der Temperatur in der Anordnung, wobei der mindestens eine Sensor (301, 302, 303, 304, 305, 306) auf einem festgelegten Element (102, 106, 112, 308) innerhalb der Anordnung (100) zum Messen der Temperatur des festgelegten Elements (102, 106, 112, 308) angeordnet ist, wobei das festgelegte Element (102, 106, 112, 308) ein beliebiges Element der Anordnung (100) innerhalb des geschlossenen Raums (104) oder außerhalb des geschlossenen Raums (104) ist, das eine feste, halbfeste oder flüssige Phase aufweist,
- eine Steuerung (210) zum Steuern mindestens einer der ersten und zweiten Strömungsregulierungsvorrichtungen (202, 206) basierend auf der mindestens einen Temperaturmessung des festgelegten Elements (102, 106, 112, 308).

2. Anordnung nach Anspruch 1, wobei das festgelegte Element (102, 104, 106, 112, 308) verkörpert ist durch:
- ein Messteil (308), das innerhalb der Anordnung (100) angeordnet ist,
- einen beliebigen Teil der elektronischen Geräte (102),
- einen beliebigen Teil des Wärmetauschers (106, 107, 108, 109),
- ein Wandelement (104, 112) der Anordnung (100) oder eine Kombination davon.

3. Anordnung nach Anspruch 2, wobei das Messteil (308) von den elektronischen Geräten (102) in das Kühlfluid (204) im geschlossenen Raum (104) vorsteht.

4. Anordnung nach Anspruch 2, wobei das Messteil (308) von einem äußeren (112) Wandelement in das äußere Kühlfluid (208) außerhalb des geschlossenen Raums vorsteht.

5. Anordnung nach Anspruch 2, wobei das festgelegte Element (102, 104, 106, 112, 308) durch einen wärmeempfindlichen Teil oder durch eine Wärmesenke auf den elektronischen Geräten (102) verkörpert ist.

6. Anordnung nach Anspruch 2, wobei das festgelegte Element (102, 104, 106, 112, 308) durch einen ersten Abschnitt (107) des Wärmetauschers (106) verkörpert ist, der im geschlossenen Raum (104) angeordnet ist.

7. Anordnung nach Anspruch 2, wobei das festgelegte Element (102, 104, 106, 112, 308) durch einen zweiten Abschnitt (108) des Wärmetauschers (106) verkörpert ist, der außerhalb (112) des geschlossenen Raums angeordnet ist.

8. Anordnung nach Anspruch 2, wobei das festgelegte Element (102, 104, 106, 112, 308) durch ein Kühlfluid (109) verkörpert ist, das im Wärmetauscher (106) zirkuliert.

9. Anordnung nach Anspruch 1 bis 4, wobei der Sensor (301, 302, 303, 304, 305, 306) ein Temperatursensor ist.

10. Anordnung nach Anspruch 8, wobei der Sensor (304) ein Drucksensor (304) zum indirekten Erfassen einer Temperatur ist.

11. Anordnung nach Anspruch 7, wobei der zweite Abschnitt (108) des Wärmetauschers (106) und die zweite Strömungsregulierungsvorrichtung (206) mit der Umgebungsluft in Kontakt stehen.

12. Anordnung nach einem der vorhergehenden Ansprüche, wobei der Funknetzknoten eine Funkbasisstation ist.

13. Verfahren in einem Funknetzknoten (100) zum Kühlen von elektronischen Geräten (102) innerhalb der Anordnung (100), wobei die Anordnung umfasst:
- einen geschlossenen Raum (104) zum Aufnehmen der elektronischen Geräte (102),
- einen Wärmetauscher (106) zum Befördern von Wärme aus dem geschlossenen Raum (104),
- eine erste Strömungsregulierungsvorrichtung (202) zum Zirkulierenlassen eines Kühlfluids (204) innerhalb des geschlossenen Raums (104),
- eine zweite Strömungsregulierungsvorrichtung (206) zum Zirkulierenlassen eines Kühlfluids (208) außerhalb (112) des geschlossenen Raums (104) zum Ableiten von Wärme aus dem Wärmetauscher (106), wobei das Verfahren die folgenden Schritte umfasst:
- Messen der Temperatur eines festgelegten Elements (102, 104, 106, 112, 308) innerhalb der Anordnung (100) mit mindestens einem Sensor (301, 302, 303, 304, 305, 306), wobei das festgelegte Element (102, 106, 112, 308) ein beliebiges Element der Anordnung (100) innerhalb des geschlossenen Raums (104) oder außerhalb des geschlossenen Raums (104) ist, das eine feste, halbfeste oder flüssige Phase aufweist, und
- Steuern mindestens einer der ersten und zweiten Strömungsregulierungsvorrichtungen (202, 206) basierend auf der mindestens einen Temperaturmessung des festgelegten Elements.

## Revendications

1. Dispositif (100) dans un noeud de radioréseau (400) pour refroidir un équipement électronique (102) à l'intérieur du dispositif (100), le dispositif comprenant :
- un espace fermé (104) pour renfermer l'équipement électronique (102),
- un échangeur thermique (106) pour transporter de la chaleur depuis l'espace fermé (104),
- un premier dispositif de régulation de débit (202) pour faire circuler un fluide de refroidissement (204) à l'intérieur de l'espace fermé (104),
- un second dispositif de régulation de débit (206) pour faire circuler un fluide de refroidissement extérieur (208) à l'extérieur (112) de l'espace fermé (104) pour dissiper la chaleur provenant de l'échangeur thermique (106),
- au moins un capteur (301,302,303,304,305,306) pour mesurer la température dans le dispositif, dans lequel le au moins un capteur (301,302,303,304,305,306) est situé sur un élément fixe (102,106,112,308) à l'intérieur du dispositif (100) pour mesurer la température de l'élément fixe (102,106,112,308), l'élément fixe (102,106,112,308) étant n'importe quel élément du dispositif (100) à l'intérieur de l'espace fermé (104) ou à l'extérieur de l'espace fermé (104) qui a une phase solide, semi-solide ou liquide,
- un contrôleur (210) pour contrôleur au moins un du premier et du second dispositifs de régulation de débit (202,206) sur la base d'au moins une mesure de température de l'élément fixe (102, 106, 112, 308) .

2. Dispositif selon la revendication 1, dans lequel l'élément fixe (102,104,106,112,308) est représenté par :
- une pièce de mesure (308) située à l'intérieur du dispositif (100),
- n'importe quelle partie de l'équipement électronique (102),
- n'importe quelle partie de l'échangeur thermique (106, 107, 108, 109) ,
- un élément de paroi (104,112) du dispositif (100),
ou une combinaison de ceux-ci.

3. Dispositif selon la revendication 2, dans lequel la pièce de mesure (308) dépasse de l'équipement électronique (102) à l'intérieur du fluide de refroidissement (204) dans l'espace fermé (104).

4. Dispositif selon la revendication 2, dans lequel la pièce de mesure (308) dépasse depuis un élément de paroi extérieur (112) à l'intérieur du fluide de refroidissement extérieur (208) à l'extérieur de l'espace fermé.

5. Dispositif selon la revendication 2, dans lequel l'élément fixe (102,104,106,112,308) est représenté par une pièce sensible à la chaleur ou par un dissipateur thermique sur l'équipement électronique (102).

6. Dispositif selon la revendication 2, dans lequel l'élément fixe (102,104,106,112,308) est représenté par une première portion (107) de l'échangeur thermique (106) située dans l'espace fermé (104).

7. Dispositif selon la revendication 2, dans lequel l'élément fixe (102,104,106,112,308) est représenté par une seconde portion (108) de l'échangeur thermique (106) située à l'extérieur (112) de l'espace fermé.

8. Dispositif selon la revendication 2, dans lequel l'élément fixe (102,104,106,112,308) est représenté par un fluide réfrigérant (109) circulant dans l'échangeur thermique (106).

9. Dispositif selon les revendications 1 à 4, dans lequel le capteur (301,302,303,304,305,306) est un capteur de température.

10. Dispositif selon la revendication 8, dans lequel le capteur (304) est un capteur de pression (304) pour détecter indirectement une température.

11. Dispositif selon la revendication 7, dans lequel la seconde portion (108) de l'échangeur thermique (106) et le second dispositif de régulation de débit (206) sont en contact avec l'air ambiant.

12. Dispositif selon une quelconque des revendications précédentes, dans lequel le noeud de radioréseau est une station de base radio.

13. Procédé dans un dispositif de noeud de radioréseau (100) pour refroidir un équipement électronique (102) à l'intérieur du dispositif (100), le dispositif comprenant :
- un espace fermé (104) pour renfermer l'équipement électronique (102),
- un échangeur thermique (106) pour transporter de la chaleur depuis l'espace fermé (104),
- un premier dispositif de régulation de débit (202) pour faire circuler un fluide de refroidissement (204) à l'intérieur de l'espace fermé (104),
- un second dispositif de régulation de débit (206) pour faire circuler un fluide de refroidissement (208) à l'extérieur (112) de l'espace fermé afin de dissiper la chaleur de l'échangeur thermique (106), le procédé comprenant les étapes consistant à :
- mesurer la température d'un élément fixe (102,104,106,112,308) à l'intérieur du dispositif (100) avec au moins un capteur (301,302,303,304,305,306), l'élément fixe (102,106,112,308) étant n'importe quel élément du dispositif (100) à l'intérieur de l'espace fermé (104) ou à l'extérieur de l'espace fermé (104) qui a une phase solide, semi-solide ou liquide,
- contrôler au moins un du premier et second dispositifs de régulation de débit (202,206) sur la base d'au moins une mesure de température de l'élément fixe.
